# FASCICULE DE BREVET EUROPEEN

(11) **EP 2 543 625 B1**
(45) Date de publication et mention de la délivrance du brevet: **15.01.2014**
(21) Numéro de dépôt: 12174856.0
(22) Date de dépôt: 03.07.2012
(51) Int. Cl.: B81C 99/00, G04B 17/06

(54) **Procédé de réalisation d'un insert métallique dans une pièce horlogère**
Verfahren zur Herstellung eines eingebetteten Metallteils in einer Uhr
Method for producing a metal insert in a timepiece

(30) Priorité: 06.07.2011 CH 11312011
(43) Date de publication de la demande: 09.01.2013
(73) Titulaire: CSEM Centre Suisse d'Electronique et de Microtechnique SA - Recherche et Développement, 2002 Neuchâtel (CH)
(72) Inventeur: Cardot, Francis, 2000 Neuchâtel (CH); Jeanneret, Sylvain, 2013 Colombier (CH)
(74) Mandataire: GLN SA

(56) Documents cités:
- EP-A1- 2 060 534
- EP-A1- 2 104 005
- WO-A2-2008/135817

## Description

### Domaine technique

La présente invention concerne des procédés de réalisation d'une cavité borgne remplie de métal ou d'un alliage métallique dans une pièce horlogère comprenant un substrat en silicium. Ladite cavité borgne remplie de métal ou d'un alliage métallique constitue un insert qui est plus spécialement destiné à être utilisé comme masse d'inertie.

### Etat de la technique

De plus en plus les pièces en silicium réalisées avec grande précision par des méthode de micro-usinage telle que la gravure ionique réactive DRIE (Deep Reactive-lon etching) trouvent leurs applications dans les domaines des microsystèmes MEMS (Micro Electro Mechanical Systems), tels des capteurs ou actionneurs, des composants micromécanique ou encore des pièces destinées à l'horlogerie.

Le silicium est apprécié pour son élasticité, son caractère amagnétique et pour sa légèreté. Néanmoins cette dernière qualité ne permet pas de réaliser complètement en silicium, et dans de petites dimensions, des composants tels qu'un balancier ou une masse oscillante qui doivent avoir une inertie ou un balourd suffisants. Il est donc nécessaire de rajouter des parties plus denses à ces pièces en silicium, par exemple des parties métalliques, comme cela est décrit dans la publication WO 2008/135817.

Les pièces en silicium comportant des parties métalliques sont le plus souvent réalisées en ajoutant à la pièce en silicium une partie métallique par insertion mécanique ou par création in-situ par voie galvanique. Dans le dernier cas la pièce en silicium possède une cavité qui traverse entièrement le substrat. Cette pièce est alors assemblée sur un support possédant des parties conductrices à partir desquelles le remplissage de la cavité par déposition galvanique d'un métal est réalisé. La pièce en silicium est ensuite séparée de son support, tel que cela est décrit dans la demande EP 1 932 804. Ce mode de fabrication entraine des étapes supplémentaires et coûteuses et présentent un risque de fragilisation des pièces lors de la séparation de la pièce intermédiaire.

Une autre approche, décrite dans la demande EP 2 104 005, consiste à d'abord créer une cavité borgne dans le substrat en silicium. Cette cavité peut être ensuite remplie de métal par voie galvanique, puis le substrat en silicium est complètement gravé afin de réaliser la forme de la pièce finale. Cette approche présente de nombreux inconvénients. Il est par exemple extrêmement difficile de graver par DRIE du silicium en présence de métal avec la précision requise pour les pièces horlogères d'une part, et d'autre part la présence de ce métal peut conduire à de graves pollutions de la machine de gravure en fonction du métal utilisé. Un autre inconvénient sérieux de cette approche est le fait que la présence de métal dans le substrat de silicium condamne les futures opérations d'oxydation du silicium qui sont nécessaires pour des besoins de procédés, des besoins de tenue mécanique et des besoins d'aspect esthétique des pièces finales réalisées.

Un objet de la présente invention est de proposer un nouveau procédé de fabrication permettant de réaliser des inserts métalliques utilisés par exemple comme masses d'inertie dans des pièces horlogères en silicium, en supprimant les problèmes rencontrés avec les procédés connus.

### Divulgation de l'invention

A cet effet, et conformément à la présente invention, il est proposé un procédé de réalisation d'une cavité borgne remplie de métal ou d'un alliage métallique dans une pièce horlogère comprenant un substrat en silicium, ledit procédé comprenant les étapes de :
- structuration préalable dudit substrat de silicium de sorte qu'il présente préalablement la forme de ladite pièce horlogère,
- formation dans ledit substrat de silicium structuré d'au moins une cavité borgne, et
- remplissage de ladite cavité d'un métal ou d'un alliage métallique.

De préférence, ladite pièce horlogère est un balancier, la cavité borgne constituant un insert métallique et étant disposée à la périphérie du balancier pour augmenter son rapport inertie/masse.

Les procédés selon l'invention permettent d'ajouter des parties métalliques qui sont formées directement dans le silicium, sans aucune pièce intermédiaire à assembler ou à séparer. Ainsi, les procédés de l'invention sont particulièrement avantageux puisqu'ils correspondent à des modes de fabrication plus simple.

### Brève description des dessins

D'autres détails de l'invention apparaîtront plus clairement à la lecture de la description qui suit, faite en référence aux dessins annexés dans lesquels :
- les figures 1 a, 1b et 1c représentent schématiquement les différentes étapes d'un premier procédé de fabrication selon l'invention,
- les figures 2a, 2b et 2c représentent schématiquement les différentes étapes d'un deuxième procédé de fabrication selon l'invention, et
- les figures 3 à 5 représentent une vue en coupe d'une pièce fabriquée selon d'autres variantes de procédé de fabrication selon l'invention.

### Modes de réalisation de l'invention

La présente invention concerne un procédé de réalisation d'une cavité borgne remplie de métal ou d'un alliage métallique dans une pièce horlogère comprenant un substrat en silicium, ledit procédé comprenant les étapes de :
- structuration préalable dudit substrat de silicium de sorte qu'il présente la forme de ladite pièce horlogère,
- formation dans ledit substrat de silicium structuré d'au moins une cavité borgne, et
- remplissage de ladite cavité d'un métal ou d'un alliage métallique.

Une telle cavité constitue un insert métallique qui peut par exemple être utilisé comme masse d'inertie, notamment lorsque la pièce horlogère est un balancier.

Dans la présente invention, la cavité borgne est définie par un fond et des parois latérales, saillant du fond. La cavité peut présenter une section, qui vue de dessus, présente toute forme géométrique appropriée, telle que polygonale ou circulaire. De préférence, le rapport entre la profondeur de la cavité et sa section est compris entre 10⁻³ et 50, de préférence entre 10⁻² et 20.

De préférence, le métal ou l'alliage métallique arrive à fleur de la surface du substrat en silicium, formant ainsi une pièce uniforme.

Selon une première variante de réalisation, le substrat est composé d'un bloc monolithique de silicium. De préférence, ledit bloc monolithique de silicium est un silicium conducteur présentant une résistivité inférieure à 1000 Ohm/cm². Le silicium peut être monocristallin ou polycristallin. Il présente une épaisseur correspondant à l'épaisseur de la pièce, par exemple comprise entre 100 µm et 750 µm.

D'une manière avantageuse, la cavité peut présenter un fond constitué par le substrat en silicium. Selon une autre possibilité, la cavité peut présenter un fond constitué par une couche de silicium poreux d'une épaisseur supérieure à 0,1 µm, formé à partir du substrat.

Avantageusement, la cavité peut présenter des parois dont au moins la partie supérieure, par exemple la moitié supérieure de la hauteur de la cavité, est couverte d'un matériau isolant.

De préférence, la cavité peut présenter des parois couvertes d'un matériau isolant.

Selon une deuxième variante de réalisation, le substrat comprend une première couche de silicium de résistivité R1 inférieure à 1000 Ohm/cm², et une deuxième couche de silicium conducteur de résistivité R2 telle que R2 ≥ 100R1, et de préférence R2 ≥ 500R1. Le silicium de chaque couche peut être monocristallin ou polycristallin. Le substrat présente une épaisseur correspondant à l'épaisseur de la pièce, par exemple comprise entre 150 µm et 750 µm.

D'une manière avantageuse, la cavité peut présenter des parois constituées par au moins la deuxième couche de silicium.

Selon une troisième variante de réalisation, le substrat comprend une première couche de silicium de résistivité R1 inférieure à 1000 Ohm/cm², et une deuxième couche de silicium conducteur de résistivité R3 telle que R3<100R1. Le silicium de chaque couche peut être monocristallin ou polycristallin. Le substrat présente une épaisseur correspondant à l'épaisseur de la pièce, par exemple comprise entre 100 µm et 750 µm.

Pour l'une ou l'autre des deuxième et troisième variantes, au moins la partie supérieure des parois de la cavité, par exemple la moitié supérieure de la hauteur de la cavité, peut être couverte d'un matériau isolant.

Pour l'une ou l'autre des deuxième et troisième variantes, la cavité peut présenter des parois couvertes d'un matériau isolant.

Pour l'une ou l'autre des deuxième et troisième variantes, le fond de la cavité peut être constitué par la première couche de silicium ou par une couche de silicium poreux d'une épaisseur supérieure à 0,1 µm, formé à partir du substrat le plus conducteur.

Pour l'une ou l'autre des deuxième et troisième variantes, la cavité peut présenter des parois dont la partie inférieure, par exemple la moitié inférieure de la hauteur de la cavité, est constituée par la première couche de silicium.

Pour l'une ou l'autre des deuxième et troisième variantes, ledit substrat peut comprendre une couche d'oxyde de silicium prévue entre les première et deuxième couches de silicium, soit un substrat créé en utilisant une méthode de type SOI (Silicon On Insulator).

De préférence, lorsque les parois de la cavité sont couvertes au moins partiellement d'un matériau isolant, ledit matériau isolant est choisi parmi le groupe comprenant un oxyde d'un élément semi-conducteur, tel que silicium ou germanium, un nitrure d'un élément semi-conducteur tel que silicium ou germanium, un oxyde métallique et un nitrure métallique. De préférence, ledit matériau isolant est un oxyde thermique de silicium.

De préférence, le métal utilisé pour remplir la cavité borgne est de l'or ou du platine, et l'alliage métallique est à base d'or ou de platine.

La pièce horlogère obtenue à partir du procédé de l'invention peut être plus particulièrement un balancier, la cavité borgne étant disposée à la périphérie du balancier pour augmenter son rapport inertie/masse.

Selon des variantes de réalisation, le procédé selon l'invention peut comprendre en outre une étape de formation d'un fond conducteur de la cavité, l'étape de remplissage de la cavité étant avantageusement réalisée par le dépôt d'un métal ou d'un alliage métallique par voie galvanique à partir dudit fond conducteur de la cavité, en contactant le substrat conducteur ou la première couche conductrice de silicium.

De préférence, lorsque le substrat comprend une première couche de silicium de résistivité R1, et une deuxième couche de silicium conducteur de résistivité R2 telle que R2 ≥ 100R1, la cavité est creusée dans la deuxième couche jusqu'à atteindre la première couche de silicium conducteur de faible résistivité, qui constitue alors le fond de ladite cavité.

De préférence, lorsque le substrat est composé d'un bloc monolithique de silicium ou comprend une première couche de silicium de résistivité R1 inférieure à 1000 Ohm/cm² et une deuxième couche de silicium conducteur de résistivité R3 telle que R3<100R1, le procédé selon l'invention peut comprendre en outre, préalablement à l'étape de formation d'un fond conducteur, une étape de dépôt sur le substrat d'une couche d'un matériau isolant, l'étape de formation du fond conducteur consistant à éliminer ledit matériau isolant dans au moins le fond de la cavité, et éventuellement d'une partie inférieure des parois de la cavité. Toutefois, de préférence, seul le fond de la cavité est mis à nu de sorte que le dépôt de métal s'effectue uniquement sur le fond de la cavité et non ou peu sur les parois.

Selon d'autres variantes du procédé selon l'invention, l'étape de remplissage de la cavité peut être réalisée par la coulée d'un métal ou d'un alliage métallique dans la cavité.

Selon d'autres variantes du procédé selon l'invention, l'étape de remplissage de la cavité peut être réalisée par l'application d'une pâte ou d'une poudre contenant un métal, un alliage métallique ou tout autre composé métallique (oxyde) dans la cavité.

Dans le cas des substrats de type SOI, les couches ou plaques inférieure et supérieure peuvent avoir été structurées avant leur assemblage.

Avantageusement, la cavité est formée par gravure ionique réactive profonde (DRIE) ou tout autre procédé approprié.

On obtient ainsi une pièce en silicium avec des ajouts de parties métalliques formées directement dans le silicium. Le procédé ne comprend pas d'étapes supplémentaires d'assemblage ou de séparation de pièce intermédiaire pour obtenir la pièce en composite silicium-métal.

Les exemples suivants illustrent la présente invention sans toutefois en limiter la portée.

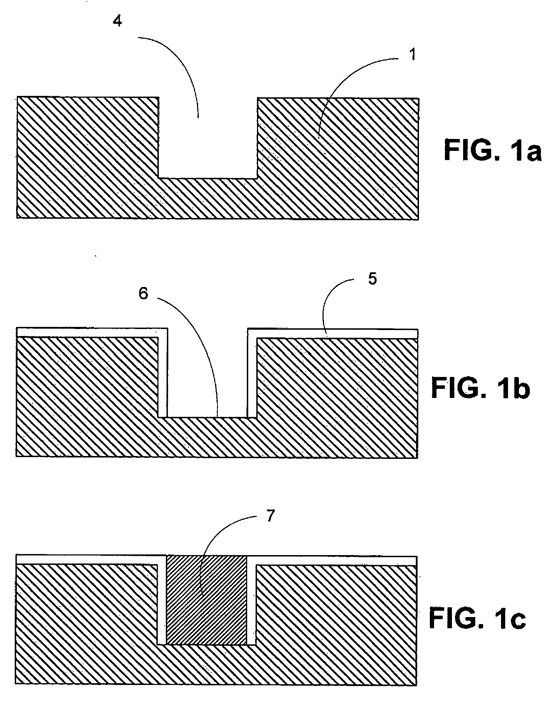

Une première variante de réalisation est représentée schématiquement sur les figures 1a à 1c.

Dans cette première approche, un substrat 1 en silicium conducteur de résistivité inférieure à 1000 Ohm/cm², monocristallin ou polycristallin, est préalablement structuré de façon à réaliser la pièce de forme désirée. Ce substrat comporte au moins une cavité borgne 4, telle que représentée sur la figure 1a. Le substrat 1 est ensuite recouvert d'une couche isolante 5, par exemple en oxyde thermique de silicium. La couche isolante 5 est gravée de manière anisotrope par DRIE dans la cavité 4 de façon à mettre à nu le fond conducteur 6 en silicium tout en laissant du matériau isolant 5 sur les parois de cette cavité 4. Le remplissage de la cavité 4 depuis son fond conducteur 6 par un métal ou un alliage 7 par voie galvanique est effectué en contactant le substrat conducteur en silicium 1, créant ainsi in-situ une pièce horlogère en composite silicium/métal. Il est à noter que le fond 6 et les parois de la cavité 4 peuvent être constitués de silicium conducteur non-isolé.

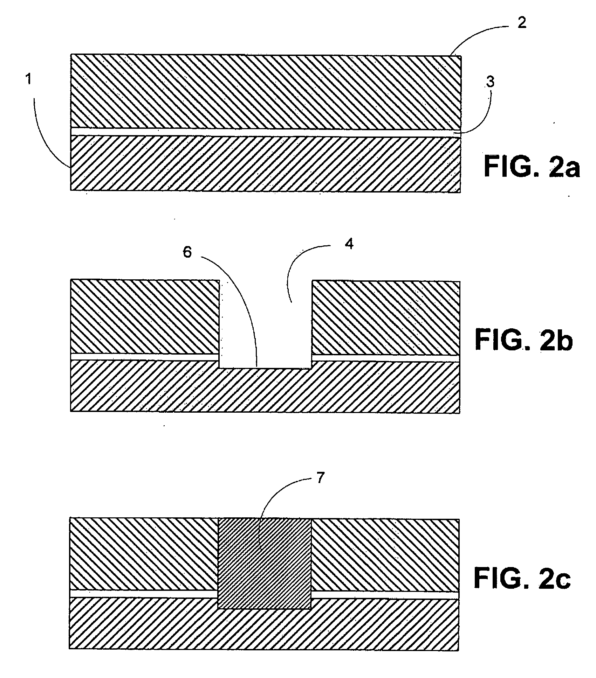

Une autre variante de réalisation est représentée sur les figures 2a à 2c.

Dans cette deuxième approche, le substrat en silicium est créé en utilisant une méthode de type SOI (Silicon On Insulator) dans laquelle une plaque inférieure 1 en silicium de résistivité inférieure à 1000 Ohm/cm² (monocristallin ou polycristallin) est liée à une autre plaque supérieure 2 en silicium (monocristallin ou polycristallin) de forte résistivité, une couche d'oxyde de silicium 3 étant prévue à l'interface entre les deux plaques 1 et 2, tel que le montre la figure 2a. La résistivité de la plaque supérieure 2 est environ 500 fois plus élevée que celle de la plaque inférieure 1.

Le substrat en silicium est préalablement structuré de façon à réaliser la pièce de forme désirée. Une cavité borgne 4 est percée dans la plaque de silicium supérieure 2 et la couche d'oxyde 3 jusqu'à atteindre au moins la surface du silicium conducteur de la plaque inférieure 1, tel que le montre la figure 2b. Le rapport entre la profondeur de cette cavité 4 sur sa section est dans le domaine 10⁻³-50, de préférence 10⁻²-20. Le fond 6 de la cavité 4 présente alors une conductivité beaucoup plus élevée que celle de ses parois. Le remplissage de cette cavité 4 par un métal ou un alliage 7 peut alors s'effectuer depuis son seul fond conducteur 6 par voie galvanique en contactant la plaque inférieure 1 en silicium conducteur, peu ou pas dépôt s'effectuant sur les parois. Ainsi est créée in-situ une pièce horlogère en composite silicium/métal. Le matériau de remplissage peut être de l'or, du platine ou un alliage d'or ou de platine.

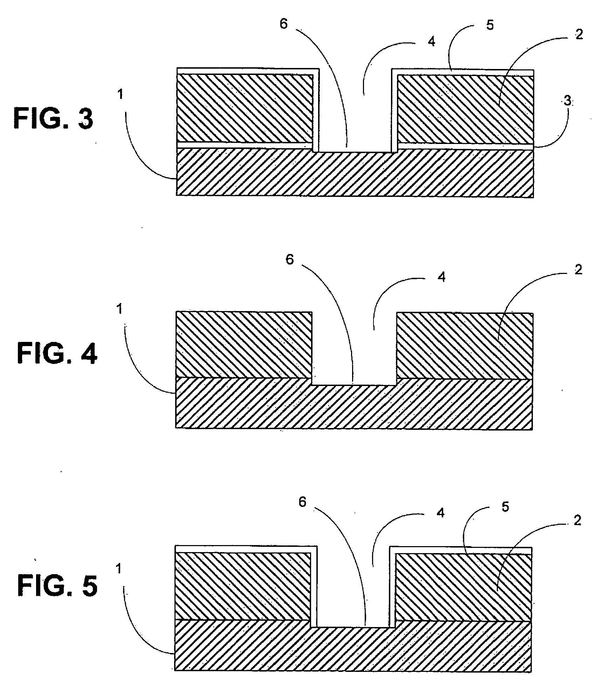

D'autres variantes relatives à la deuxième approche sont présentées sur les figures 3 à 5.

La figure 3 présente un substrat de type SOI dont la plaque supérieure 2 en en silicium (monocristallin ou polycristallin) est de résistivité quelconque R3, notamment telle que R3<100R1, R1 étant la résistivité de la plaque inférieure 1. Dans ce cas, après le perçage de la cavité borgne 4 jusqu'au silicium de la plaque 1, le substrat est recouvert d'une couche isolante 5, par exemple en oxyde thermique de silicium. La couche isolante 5 est gravée de manière anisotrope dans la cavité 4 de façon à mettre à nu le fond conducteur en silicium 6 tout en laissant du matériau isolant sur les parois de cette cavité.

La figure 4 présente un substrat réalisé par la soudure direct de deux plaques de silicium, une plaque inférieure 1 en silicium (monocristallin ou polycristallin) de résistivité inférieure à 1000 Ohm/cm2 (monocristallin ou polycristallin) et une plaque supérieure 2 en silicium de forte résistivité. La résistivité de la plaque supérieure 2 est environ 500 fois plus élevée que celle de la plaque inférieure 1. La cavité borgne 4 est percée à travers la plaque de silicium supérieure 2 jusqu'à atteindre le silicium conducteur de la plaque inférieure 1. Le fond 6 de la cavité 4 présente alors une conductivité beaucoup plus élevée que celle de ses parois.

La figure 5 présente un substrat réalisé par la soudure direct de deux plaques de silicium, une plaque inférieure 1 en silicium (monocristallin ou polycristallin) de résistivité inférieure à 1000 Ohm/cm2 et une plaque supérieure 2 en silicium (monocristallin ou polycristallin) de résistivité quelconque R3, notamment telle que R3<100R1, R1 étant la résistivité de la plaque inférieure 1. Après le perçage de la cavité borgne 4 jusqu'au silicium de la plaque 1, le substrat est recouvert d'une couche isolante 5, par exemple en oxyde thermique de silicium. La couche isolante 5 est gravée de manière anisotrope dans la cavité 4 de façon à mettre à nu le fond conducteur en silicium 6 tout en laissant du matériau isolant 5 sur les parois de cette cavité 4.

## Revendications

1. Procédé de réalisation d'une cavité (4) borgne remplie de métal ou d'un alliage métallique (7) dans une pièce horlogère comprenant un substrat en silicium (1, 2), **caractérisé en ce qu'**il comprend les étapes de :
- structuration préalable dudit substrat de silicium (1, 2) de sorte qu'il présente préalablement la forme de ladite pièce horlogère,
- formation dans ledit substrat de silicium structuré (1, 2) d'au moins une cavité borgne (4), et
- remplissage de ladite cavité (4) d'un métal ou d'un alliage métallique (7).

2. Procédé selon la revendication 1, **caractérisé en ce qu'**il comprend en outre une étape de formation d'un fond conducteur (6) de la cavité (4) et **en ce que** l'étape de remplissage de la cavité (4) est réalisée par le dépôt d'un métal ou d'un alliage métallique (7) par voie galvanique à partir dudit fond conducteur (6) de la cavité (4).

3. Procédé selon la revendication 1, **caractérisé en ce que** l'étape de remplissage de la cavité (4) est réalisée par la coulée d'un métal ou d'un alliage métallique dans la cavité (4).

4. Procédé selon la revendication 1, **caractérisé en ce que** l'étape de remplissage de la cavité (4) est réalisée par l'application d'une pâte contenant un métal ou un alliage métallique dans la cavité (4).

5. Procédé selon l'une quelconque des revendications précédentes, **caractérisé en ce que** ledit substrat (1) est composé d'un bloc monolithique de silicium.

6. Procédé selon la revendication 5, **caractérisé en ce que** ledit bloc monolithique de silicium présente une résistivité inférieure à 1000 Ohm/cm².

7. Procédé selon l'une quelconque des revendications 5 à 6, **caractérisé en ce que** la cavité (4) présente un fond (6) constitué par le substrat en silicium (1).

8. Procédé selon l'une quelconque des revendications 5 à 6, **caractérisé en ce que** la cavité présente un fond constitué par une couche de silicium poreux.

9. Procédé selon l'une quelconque des revendications 5 à 8, **caractérisé en ce que** la cavité (4) présente des parois dont au moins la partie supérieure est couverte d'un matériau isolant (5).

10. Procédé selon la revendication 9, **caractérisé en ce que** la cavité (4) présente des parois couvertes d'un matériau isolant (5).

11. Procédé selon l'une quelconque des revendications 1 à 4, **caractérisé en ce que** ledit substrat de silicium (1, 2) comprend une première couche de silicium de résistivité R1 inférieure à 1000 Ohm/cm², et une deuxième couche de silicium conducteur de résistivité R2 telle que R2 ≥ 100R1.

12. Procédé selon la revendication 11, **caractérisée en ce que** la cavité (4) présente des parois constituées par au moins la deuxième couche de silicium.

13. Procédé selon l'une quelconque des revendications 1 à 4, **caractérisé en ce que** ledit substrat (1, 2) comprend une première couche de silicium de résistivité R1 inférieure à 1000 Ohm/cm², et une deuxième couche de silicium conducteur de résistivité R3 telle que R3<100R1.

14. Procédé selon l'une quelconque des revendications 11 à 13, **caractérisé en ce que** au moins la partie supérieure des parois de la cavité (4) est couverte d'un matériau isolant (5).

15. Procédé selon la revendication 14, **caractérisé en ce que** la cavité (4) présente des parois couvertes d'un matériau isolant (5).

16. Procédé selon l'une quelconque des revendications 11 à 15, **caractérisé ce que** la cavité (4) présente un fond (6) constitué par la première couche de silicium.

17. Procédé selon l'une quelconque des revendications 11 à 15, **caractérisé en ce que** la cavité présente un fond constitué par une couche de silicium poreux.

18. Procédé selon l'une quelconque des revendications 11 à 17, **caractérisé en ce que** la cavité (4) présente des parois dont la partie inférieure est constituée par la première couche de silicium.

19. Procédé selon l'une quelconque des revendications 11 à 18, **caractérisé en ce que** ledit substrat (1, 2) comprend une couche d'oxyde de silicium (3) prévue entre les première et deuxième couches de silicium.

20. Procédé selon l'une quelconque des revendications 9, 10, 14 et 15, **caractérisé en ce que** ledit matériau isolant (5) est choisi parmi le groupe comprenant un oxyde d'un élément semi-conducteur, un nitrure d'un élément semi-conducteur, un oxyde métallique et un nitrure métallique.

21. Procédé selon l'une quelconque des revendications précédentes, **caractérisé en ce que** le rapport entre la profondeur de la cavité et sa section est compris entre 10⁻³ et 50, de préférence entre 10⁻² et 20.

22. Procédé selon l'une quelconque des revendications précédentes, **caractérisé en ce que** la pièce horlogère consiste en un balancier et **en ce que** la cavité borgne est disposée à la périphérie du balancier pour augmenter son rapport inertie/masse.

## Patentansprüche

1. Verfahren zur Herstellung eines mit Metall oder einer Metalllegierung (7) gefüllten Sackhohlraums (4) in einer Uhr, die ein Siliziumsubstrat (1, 2) umfasst, **dadurch gekennzeichnet, dass** es die folgenden Schritte umfasst:
- vorherige Strukturierung des Siliziumsubstrats (1, 2) derart, dass es vorher die Form der Uhr aufweist,
- Ausbildung mindestens eines Sackhohlraums (4) in dem strukturierten Siliziumsubstrat (1, 2), und
- Füllen des Hohlraums (4) mit einem Metall oder einer Metallegierung (7).

2. Verfahren nach Anspruch 1, **dadurch gekennzeichnet, dass** es ferner einen Ausbildungsschritt eines leitenden Bodens (6) des Hohlraums (4) umfasst und dass der Schritt des Füllens des Hohlraums (4) durch Beschichtung mit einem Metall oder einer Metalllegierung (7) auf galvanischem Weg ab dem leitenden Boden (6) des Hohlraums (4) durchgeführt wird.

3. Verfahren nach Anspruch 1, **dadurch gekennzeichnet, dass** der Schritt des Füllens des Hohlraums (4) durch Gießen eines Metalls oder einer Metalllegierung in den Hohlraum (4) durchgeführt wird.

4. Verfahren nach Anspruch 1, dadurch gekennzeichet, dass der Schritt des Füllens des Hohlraums (4) durch Auftragen einer Paste, die ein Metall oder eine Metallegierung enthält, in den Hohlraum (4) durchgeführt wird.

5. Verfahren nach einem der vorangehenden Ansprüche, **dadurch gekennzeichnet, dass** das Substrat (1) aus einem monolithischen Siliziumblock zusammengesetzt ist.

6. Verfahren nach Anspruch 5, **dadurch gekennzeichnet, dass** der monolithische Siliziumblock einen spezifischen Widerstand unter 1000 Ohm/cm² aufweist.

7. Verfahren nach einem der Ansprüche 5 bis 6, **dadurch gekennzeichnet, dass** der Hohlraum (4) einen Boden (6) aufweist, der von dem Siliziumsubstrat (1) gebildet wird.

8. Verfahren nach einem der Ansprüche 5 bis 6, **dadurch gekennzeichnet, dass** der Hohlraum einen Boden aufweist, der von einer porösen Siliziumschicht gebildet wird.

9. Verfahren nach einem der Ansprüche 5 bis 8, **dadurch gekennzeichnet, dass** der Hohlraum (4) Wände aufweist, von denen mindestens der obere Teil mit einem isolierenden Material (5) bedeckt ist.

10. Verfahren nach Anspruch 9, **dadurch gekennzeichnet, dass** der Hohlraum (4) Wände aufweist, die mit einem isolierenden Material (5) bedeckt sind.

11. Verfahren nach einem der Ansprüche 1 bis 4, **dadurch gekennzeichnet, dass** das Siliziumsubstrat (1, 2) eine erste Siliziumschicht mit einem spezifischen Widerstand R1 unter 1000 Ohm/cm² und eine zweite leitende Siliziumschicht mit einem spezifischen Widerstand R2 von R2 ≥ 100R1 umfasst.

12. Verfahren nach Anspruch 11, **dadurch gekennzeichnet, dass** der Hohlraum (4) Wände aufweist, die von mindestens der zweiten Siliziumschicht gebildet werden.

13. Verfahren nach einem der Ansprüche 1 bis 4, **dadurch gekennzeichnet, dass** das Substrat (1, 2) eine erste Siliziumschicht mit einem spezifischen Widerstand R1 unter 1000 Ohm/cm² und eine zweite leitende Siliziumschicht mit einem spezifischen Widerstand R3 von R3 < 100R1 umfasst.

14. Verfahren nach einem der Ansprüche 11 bis 13, **dadurch gekennzeichnet, dass** mindestens der obere Teil der Wände des Hohlraums (4) mit einem isolierenden Material (5) bedeckt ist.

15. Verfahren nach Anspruch 14, **dadurch gekennzeichnet, dass** der Hohlraum (4) Wände aufweist, die mit einem isolierenden Material (5) bedeckt sind.

16. Verfahren nach einem der Ansprüche 11 bis 15, **dadurch gekennzeichnet, dass** der Hohlraum (4) einen Boden (6) aufweist, der von der ersten Siliziumschicht gebildet wird.

17. Verfahren nach einem der Ansprüche 11 bis 15, **dadurch gekennzeichnet, dass** der Hohlraum einen Boden aufweist, der von einer porösen Siliziumschicht gebildet wird.

18. Verfahren nach einem der Ansprüche 11 bis 17, **dadurch gekennzeichnet, dass** der Hohlraum (4) Wände aufweist, deren unterer Teil von der ersten Siliziumschicht gebildet wird.

19. Verfahren nach einem der Ansprüche 11 bis 18, **dadurch gekennzeichnet, dass** das Substrat (1, 2) eine Siliziumoxidschicht (3) umfasst, die zwischen der ersten und zweiten Siliziumschicht vorgesehen ist.

20. Verfahren nach einem der Ansprüche 9, 10, 14 und 15, **dadurch gekennzeichnet, dass** das isolierende Material (5) aus der Gruppe ausgewählt ist, die ein Oxid eines Halbleiterelements, ein Nitrid eines Halbleiterelements, ein Metalloxid und ein Metallnitrid umfasst.

21. Verfahren nach einem der vorangehenden Ansprüche, **dadurch gekennzeichnet, dass** das Verhältnis zwischen der Tiefe des Hohlraums und seinem Schnitt zwischen 10⁻³ und 50, vorzugsweise zwischen 10⁻² und 20, inklusive ist.

22. Verfahren nach einem der vorangehenden Ansprüche, **dadurch gekennzeichnet, dass** die Uhr aus einer Unruh besteht und dass der Sackhohlraum am Umfang der Unruh anbeordnet ist, um ihr Verhältnis Trägheit/Masse zu vergrößern.

## Claims

1. A method for producing a blind cavity (4) filled with metal or a metal alloy (7) in a timepiece comprising a silicon substrate (1, 2), **characterized in that** it comprises the following steps:
- prior structuring of said silicon substrate (1, 2) such that it has the shape of said timepiece beforehand,
- forming at least one blind cavity (4) in said structured silicon substrate (1, 2), and
- filling said cavity (4) with a metal or metal alloy (7).

2. The method according to claim 1, **characterized in that** it further comprises a step for forming a conductive bottom (6) of the cavity (4) and **in that** the step for filling the cavity (4) is done by depositing a metal or metal alloy (7) using a galvanic method from said conductive bottom (6) of the cavity (4).

3. The method according to claim 1, **characterized in that** the step for filling the cavity (4) is done by pouring a metal or a metal alloy into the cavity (4).

4. The method according to claim 1, **characterized in that** the step for filling the cavity (4) is done by applying a paste containing a metal or a metal alloy into the cavity (4).

5. The method according to any one of the preceding claims, **characterized in that** said substrate (1) is made up of a monolithic silicon block.

6. The method according to claim 5, **characterized in that** said monolithic silicon block has a resistivity below 1000 Ohm/cm².

7. The method according to any one of claims 5 to 6, **characterized in that** the cavity (4) has a bottom (6) formed by said silicon substrate (1).

8. The method according to any one of claims 5 to 6, **characterized in that** the cavity has a bottom made up of a layer of porous silicon.

9. The method according to any one of claims 5 to 8, **characterized in that** the cavity (4) has walls whereof at least the upper part is covered with an insulating material (5).

10. The method according to claim 9, **characterized in that** the cavity (4) has walls covered with insulating material (5).

11. The method according to any one of claims 1 to 4, **characterized in that** said silicon substrate (1, 2) comprises a first layer of silicon with a resistivity R1 below 1000 Ohm/cm², and a second conductive silicon layer with a resistivity R2 such that R2 ≥ 100R1.

12. The method according to claim 11, **characterized in that** the cavity (4) has walls formed by at least the second silicon layer.

13. The method according to any one of claims 1 to 4, **characterized in that** said substrate (1, 2) comprises a first layer of silicon with a resistivity R1 of less than 1000 Ohm/cm², and a second conductive silicon layer with a resistivity R3 such that R3<100R1.

14. The method according to any one of claims 11 to 13, **characterized in that** at least the upper part of the walls of the cavity (4) is covered with insulating material (5).

15. The method according to claim 14, **characterized in that** the cavity (4) has walls covered with insulating material (5).

16. The method according to any one of claims 11 to 15, **characterized in that** the cavity (4) has a bottom (6) formed by the first silicon layer.

17. The method according to any one of claims 11 to 15, **characterized in that** the cavity has a bottom formed by a porous silicon layer.

18. The method according to any one of claims 11 to 17, **characterized in that** the cavity (4) has walls whereof the lower part is formed by the first silicon layer.

19. The method according to any one of claims 11 to 18, **characterized in that** said substrate (1, 2) comprises a layer of silicon oxide (3) provided between the first and second silicon layers.

20. The method according to any one of claims 9, 10, 14 and 15, **characterized in that** said insulating material (5) is chosen from along the group comprising an oxide of a semiconductor element, a nitride of a semiconductor element, a metal oxide and a metal nitride.

21. The method according to any one of the preceding claims, **characterized in that** the ratio between the depth of the cavity and its section is comprised between 10⁻³ and 50, preferably between 10⁻² and 20.

22. The method according to any one of the preceding claims, **characterized in that** the timepiece consists of a balance and **in that** the blind cavity is positioned on the periphery of the balance to increase its inertia/mass ratio.
